# EUROPEAN PATENT SPECIFICATION

(11) **EP 0 878 836 B1**
(45) Date of publication and mention of the grant of the patent: **14.02.2007**
(21) Application number: 98303917.3
(22) Date of filing: 18.05.1998
(51) Int. Cl.: H01L 21/768

(54) **Planarising a semiconductor substrate**
Planarisierung von einem Halbleitersubstrat
Planarisation d'un substrat semiconducteur

(30) Priority: 17.05.1997 KR 9719115
(43) Date of publication of application: 18.11.1998
(73) Proprietor: SAMSUNG ELECTRONICS CO., LTD., Suwon City, Kyungki-do (KR)
(72) Inventor: Kin, Chang-Gyu, Gundang-ku, Sungnam-shi, Kyunggi-do (KR); Choi, Ji-Hyun, Youngdeungpo-ku, Seoul (KR); Hong, Seok-Ji, Paldal-ku, Suwon, Kyunggi-do (KR)
(74) Representative: Tunstall, Christopher Stephen

(56) References cited:
- EP-A- 0 062 722
- FR-A- 2 620 861
- US-A- 4 642 162
- US-A- 5 266 525
- US-A- 5 541 427
- "RELIABLE TUNGSTEN CHEMICAL VAPOR DEPOSITION PROCESS WITH SPUTTER ETCH TO FORM CONTACT STUDS" IBM TECHNICAL DISCLOSURE BULLETIN, vol. 30, no. 10, 1 March 1988 (1988-03-01), page 162/163 XP000111112 ISSN: 0018-8689

## Description

### Background of the Invention

The present invention relates to a method for planarising a substrate such as a semiconductor substrate.

With the increase in integration density of semiconductor devices, much effort has been dedicated to planarisation processes, for planarising the surface of the device between formation of the various layers required. Examples include planarising an interlayer insulating layer formed on a semiconductor substrate. Recently, STI (Shallow Trench Isolation) processes have become widely used to electrically isolate device elements on a semiconductor substrate. Compared to the former LOCOS process, a step height between a trench and adjacent device elements is increased, and requires improved planarisation techniques.

Several methods are known for planarising insulating layers. Examples include: BPSG (Boron Phosphorus Silicate Glass) reflow; SOG (Spin On Glass) or photoresist and etch back; and CMP (Chemical Mechanical Polishing). Particularly, CMP can be used to planarise over a wider area than the other processes, and may be performed at a low temperature. Because of these advantages, CMP has come into wide use in substrate planarisation. CMP planarising is disclosed in, for example, US patent No. 5,064,683, issued Feb. 27, 1996.

However, substrate planarisation using CMP leads to three main problems: first, when large areas are to be planarised, a dish-shape is formed in the surface. Second, the substrate may be contaminated by the slurry used. Third, the substrate and the polishing apparatus may be contaminated by particles generated during the CMP.

US 5,541,427 and US 5,266,525 describe a substrate having a planarised upper surface and comprising elevated and a recessed regions. A first insulating layer is provided on the elevated and recessed regions and a portion of a second insulating layer overlies the first insulating layer in the recessed regions. A third insulating layer fills the recess to a level substantially coplanar with the first insulating layer. Parts of the second insulating layer are exposed at the planarised upper surface.

### Summary of the Invention

The present invention is intended to address the above problems, by providing a method for efficiently planarising a substrate which does not involve polishing.

According to one aspect of the present invention, there is provided a method for planarising a substrate, comprising the steps of: (a) preparing a substrate having an uneven topography, including an elevated region and an adjacent recessed region; (b) forming a first insulating layer on the elevated region and the recessed region; (c) forming a second insulating layer on the first insulating layer; (d) removing portions of the second insulating layer at an interface between the elevated region and the recessed region, to isolate a portion of the second insulating layer within the recessed region from a portion of second insulating layer overlying the elevated region; (e) forming a third insulating layer on the resultant surface; (f) partially removing the third insulating layer from its upper surface until a part of the portion of second insulating layer overlying the elevated region is exposed; and(g) removing the portion of second insulating layer overlying the elevated region, causing lift-off of corresponding portions of the third insulating layer.

Preferably, steps (f) and (g) are performed in a single etch process, the conditions of such process being selected such that the second insulating layer is etched at a faster rate than the third insulating layer or the first insulating layer. Such an etch process is preferably selected to completely remove the portion of second insulating layer overlying the elevated region before the portion of the second insulating layer within the recessed region is exposed by removal of an overlying part of the third insulating layer.

Preferred examples of an etch process for use in step (f) and/or step (g) are wet etching, using a solution of hydrogen fluoride HF; alternatively wet etching, using SC1(NH₃ + H₂O₂ + water) .

An underlying portion of the first insulating layer is preferably partially removed during, or subsequent to, the step (d).

The step (d) and the step of partially removing an underlying portion of the first insulating layer may be performed by a sputtering process using argon gas.

Steps (c) and (d) are preferably concurrently performed. In such a case, the second insulating layer is deposited and at the same time etched, and portions of the second insulating layer at the interface are etched faster than other portions of the second insulating layer. Underlying portions of the first insulating layer at the interface are thereby exposed.

By using the method of the present invention, there is provided a substrate having a planarised upper surface, comprising an elevated region and an adjacent recessed region, a first insulating layer on the elevated region and the recessed region, a portion of a second insulating layer overlying the first insulating layer within the recessed region and a third insulating layer filling the recessed region to a level substantially coplanar with an upper surface of the first insulating layer, characterised in that the third insulating layer encloses the portion of the second insulating layer within the recessed region whereby no part of the second insulating layer is exposed to the planarised upper surfaces.

The elevated region may comprise a patterned layer applied to the substrate, and the recessed region may comprise the substrate between elements of the patterned layer. The patterned layer may comprise an intermetal dielectric layer, or a metal interconnect layer.

Alternatively, the elevated region may comprise the substrate, and the recessed region may comprise a trench within the substrate.

Preferably, the second layer is composed of one of the group consisting of SiOF, PSG, BN and BPSG.

Preferably, the third layer is composed of one of the group consisting of HDP CVD oxide and ECR CVD oxide.

The substrate may be a semiconductor substrate.

### Brief Description of the Drawings

Certain embodiments of the present invention are described below, by way of examples only, with reference to the accompanying drawings wherein:
Figs. 1A to 1F show process steps in a method according to a first embodiment of the present invention; and
Figs. 2A to 2E show the process steps in a method according to a second embodiment of the present invention.

### Detailed Description of the Drawings

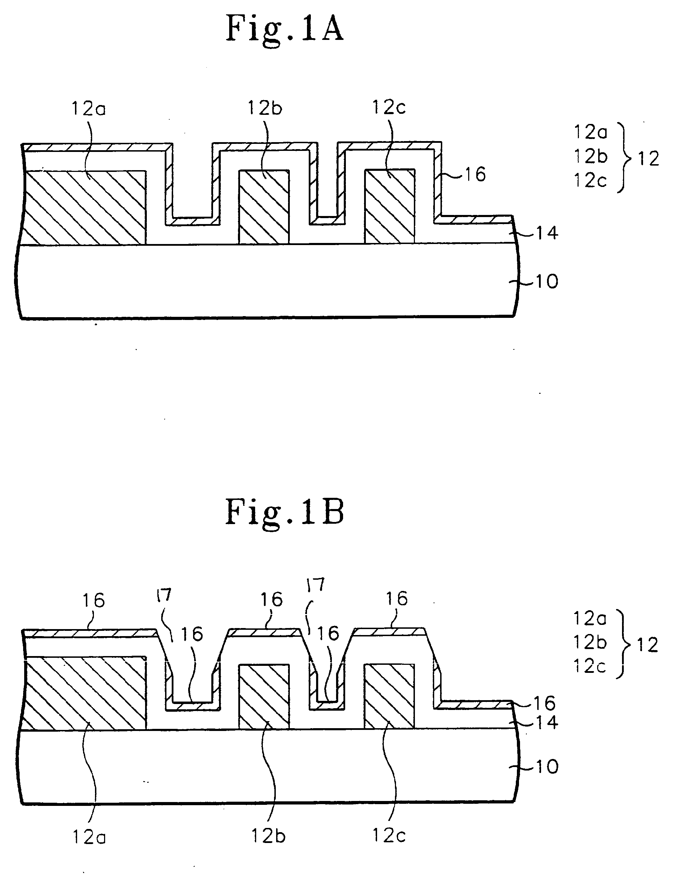

Figs. 1A to 1F show a method for planarising a semiconductor substrate according to a first embodiment of the present invention.

Referring to Fig. 1A, on a semiconductor substrate 10, a patterned layer 12 of, for example, metal interconnections 12a, 12b and 12c, is formed. The metal interconnections may have different sizes. The semiconductor substrate 10 accordingly has an uneven topography, including an elevated region (metal interconnections) and an adjacent recessed region (spaces between metal interconnections). A first insulating layer 14 is formed over the semiconductor substrate 10 including the interconnections 12a, 12b and 12c. A second insulating layer 16 is then formed over the first insulating layer. The second insulating layer may be composed of SiOF, PSG (Phosphorus Silicate Glass), BN (Boron Nitride), or BPSG (Boron Phosphorus Silicate Glass). The second insulating layer has a high etch selectivity with respect to the first insulating layer 14.

In a variant of this embodiment, the elevated region may comprise a patterned intermetal dielectric instead of metal interconnections. Similarly, the elevated region may comprise any patterned layer. Examples include polysilicon or other gate layers for transistors, or resistive lines. The recessed region may be the substrate 10 between elements 12a, 12b, 12c, of the patterned layer.

Referring to Fig. 1B, a sputtering process using argon (Ar) gas is performed until portions of the second insulating layer 16 at interfaces between the elevated regions and the recessed regions are removed. The portions of the second insulating layer within the recessed regions is thereby isolated from portions of the second insulating layer overlying the elevated regions.

Underlying portions of the first insulating layer 14 at the interfaces are preferably also partially removed. By partially removing the underlying portions of the first isolation layer, the profile of the resulting cavity 17 is rounded at its upper edges. This assists the later filling of the cavity 17.

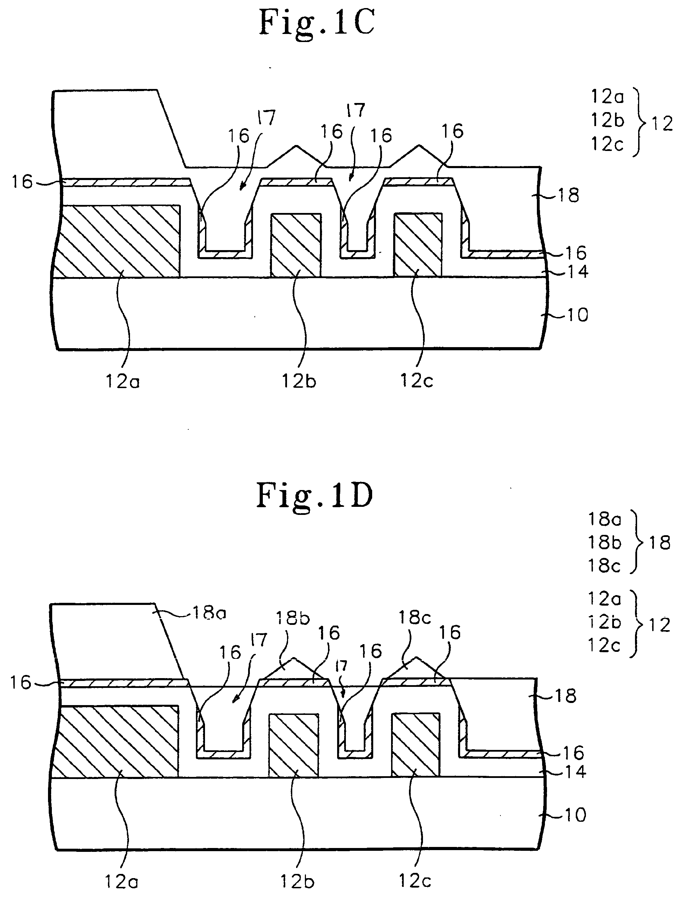

With reference to Fig. 1C, a third insulating layer 18 is formed over the resultant surface of the substrate. The third insulating layer 18 should preferably be sufficiently thick to fill cavities 17 to at least the level of the upper surface of surrounding portions of the second insulating layer. The third insulating layer may be composed of silicon oxide (SiO₂) and be formed by a CVD (Chemical Vapour Deposition) process, such as an HDP (High Density Plasma) process, or an ECR (Electron Cyclotron Resonance) process. The second insulating layer 16 must be highly selectively etchable with respect to the third insulating layer 18.

During formation of the third insulating layer, deposition and etching may be simultaneously performed.

The metal interconnection 12a having a large pattern size becomes coated with a thick third insulating layer portion 18a, having a large step height from the level of the second insulating layer. The metal interconnections 12b and 12c become coated with thinner portions 18b, 18c of the third insulating layer on top of corresponding portions of the second insulating layer.

Figs. 1D to 1F show an etching process for planarising the insulating layers. Referring to Fig. 1D, an etching, such as a wet etching, of the third insulating layer 18 is performed until end parts of the second insulating layer 16 overlying the elevated region at the interfaces are exposed.

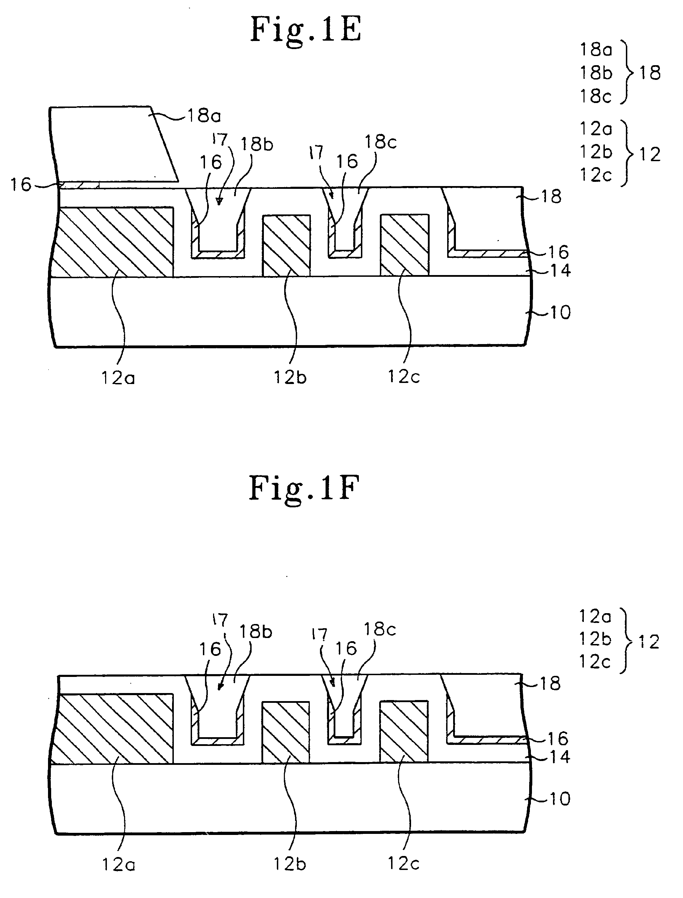

Subsequently, as shown in Figs. 1E and 1F, the etching continues, and the exposed parts of second insulating layer 16 are etched much faster than the third insulating layer 18 and exposed parts of first insulating layer 14. The materials used for the insulating layers, and the conditions used for the etching, are chosen such that the second insulating layer 16 may be completely removed from under the remaining portions of the third insulating layer, without etching the third insulating layer within cavities 17 so far that the portions of the second layer within the cavities 17 are exposed. The etch conditions used for initially etching the third insulating layer, and those used for etching the second insulating layer when it is exposed, may be the same, or different.

Even if the third insulating layer 18 formed above the metal interconnection 12a is thin, the second insulating layer 16 is removed much faster than the third insulating layer. This is because the second insulating layer 16 is selected to have a relatively high etch rate compared to the etch rates of the first and third insulating layers 14 and 18, with the chosen etch conditions. In addition, since the second insulating layer 16 is relatively thin compared to the first and third insulating layers, it can be removed far faster, as is apparent from Fig. 1E.

Figure 1E shows the structure after complete removal of the second and third layers from above the elevated regions corresponding to metal interconnections 12b and 12c. The portions of the second insulating layer formed above the metal interconnections 12b and 12c are far narrower than those formed above the metal interconnection 12a. In addition, the portions of the third insulating layer formed above the metal interconnections 12b and 12c are thinner than those formed above the metal interconnection 12a, as shown by FIG. 1C. Accordingly, the portions of both second and third insulating layers formed above metal interconnections 12b, 12c may all be completely removed by the etch applied. The parts of the second and third insulating layers formed above the metal interconnection 12a are significantly wider, and thicker, respectively, and are only partially removed by the etching.

By continuing the etching, the portion of the second insulating layer formed above the metal interconnection 12a continues to be removed, while exposed parts of first and third insulating layers are removed only slowly, if at all.

Referring to Fig. 1F, although the third insulating layer 18 formed above the metal interconnection 12a is not completely removed, the second insulating layer 16 is removed from underneath.

Removal of the second insulating layer 16 causes lift-off of overlying portions 18a of the third insulating layer 18. Parts of the third insulating layer within cavities 17, and exposed parts of first insulating layer 14 are only slowly removed. Removal of third and first insulating layers is preferably reduced as much as possible. When the overlying portions of the third insulating layer are lifted off, the upper surfaces of the portions of the third insulating layer lying within cavities 17 are substantially coplanar with the upper surface of surrounding portions if the first insulating layer 14, overlying the elevated regions.

The substrate thereby acquires a planarised upper surface, largely corresponding to the original upper surface of the first insulating layer over elevated regions.

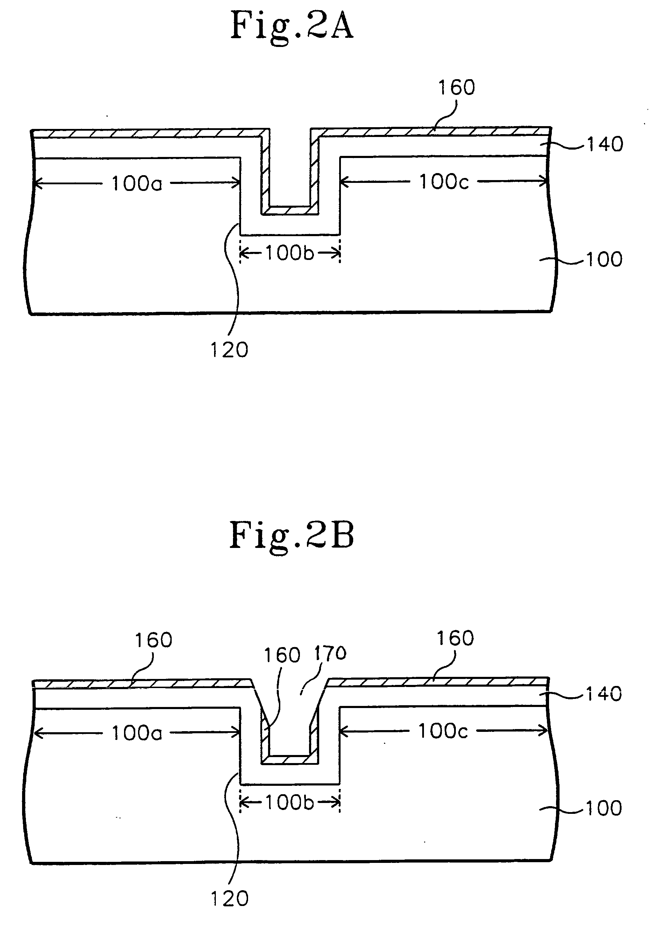

A method for planarising a semiconductor substrate according to a second embodiment of the present invention will be described with reference to Figs. 2A to 2E.

Referring to Fig. 2A, a semiconductor substrate 100 includes a trench 120 formed in its upper surface to define a device isolation region (in this case a trench isolation region). Accordingly, the semiconductor substrate 100 has an upper surface with uneven topography including an elevated region (e.g. the semiconductor substrate regions 100a and 100c adjacent to the trench 120) and an adjacent recessed region 100b (e.g. the trench 120). An insulating material is to be placed in the trench, and the upper surface of the filled trench, when completed, should be as planar as possible, coplanar with the surrounding upper surface of the substrate.

After formation of the trench 120, a first insulating layer 140 is formed on both sidewalls and the bottom of the trench 120, 100b and on the upper surface of the elevated regions 100a, 100c. A second insulating layer 160 is formed on the first insulating layer 140. Similarly to the first embodiment, the second insulating layer 160 may be composed of SiOF, PSG, BN, or BPSG, and has a high etch selectivity with respect to the first insulating layer 140.

Referring to Fig. 2B, an etching process, such as a sputtering process using argon (Ar) gas is performed until portions of the second insulating layer 160 at interfaces between the elevated regions and the recessed regions are removed. The portion of the second insulating layer within the recessed region is thereby isolated from portions of the second insulating layer overlying the elevated regions.

Underlying portions of the first insulating layer 140 at the interfaces are preferably also partially removed. By partially removing the underlying portions of the first isolation layer, the profile of the resulting cavity 170 is rounded at its upper edges. This assists the later filling of the cavity 170.

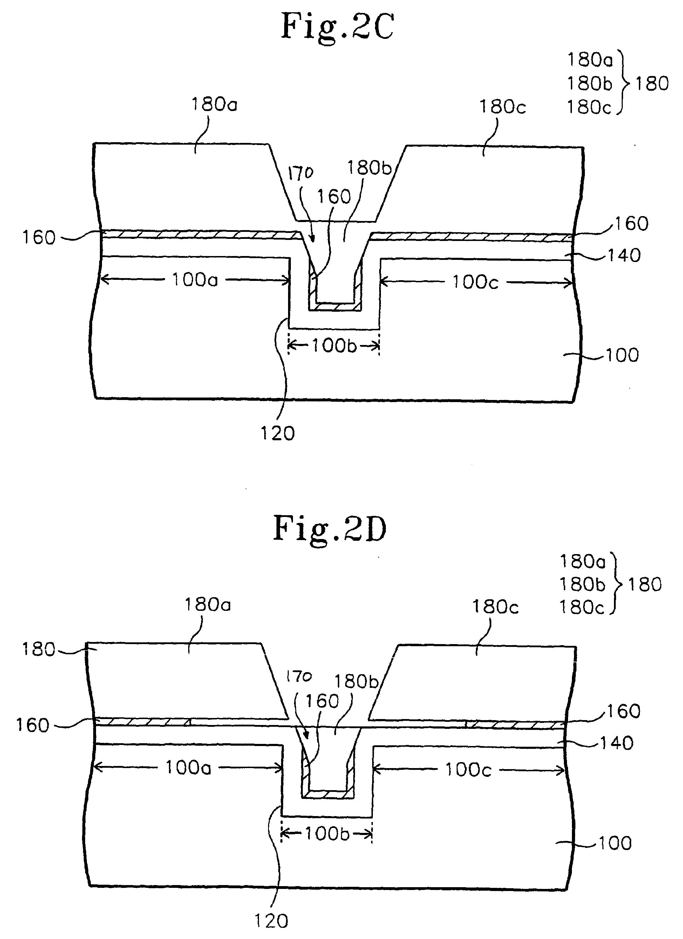

With reference to Fig. 2C, a third insulating layer 180, for example composed of silicon oxide, is formed over the substrate. A suitable process may be a CVD process such as an HDP CVD process or an ECR CVD process. The third insulating layer 180 has a high etch selectivity with respect to the second insulating layer 160. The third insulating layer 180 should preferably be sufficiently thick to fill trench 120 to at least the level of the upper surface of the surrounding portions of the second insulating layer. During formation of the third insulating layer 180, wide and thick portions 180a, 180c are formed on the elevated regions 100a and 100c, which are large in area. On the recessed region 100b, in the trench 120, is formed a part 180b of the third insulating layer, which is thin at upper edges of the trench 120, at interfaces between recessed region 100b and adjacent elevated regions 100a, 100c.

During the formation of the third insulating layer, deposition and etching may be simultaneously performed.

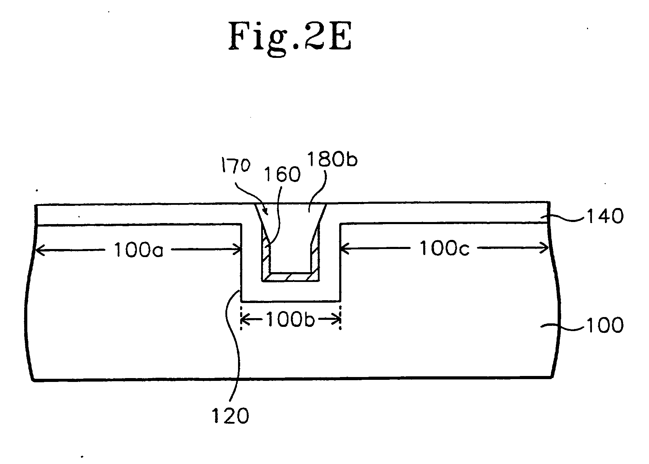

Referring to Figs. 2D and 2E, an etching step, such as a wet etching step, is performed to planarise the insulating layers.

First, as shown in Fig. 2D, etching of the third insulating layer 180 is performed until end parts of the portions of the second insulating layer 160 overlying the elevated regions are exposed, at an interface between the elevated regions and the recessed region.

Using either the same, or different, etch conditions, the exposed parts of second insulating layer 160 are etched much faster than exposed parts of the first and third insulating layers 140, 180.

Even if the third insulating layer 180 formed above the elevated regions 100a, 100c is thin, the second insulating layer 160 may be removed much faster than the third insulating layer. This is because the second insulating layer 160 has a relatively high etch rate compared to that of the first and third insulating layers 140 and 180, under the selected etch conditions. The second insulating layer 160 is also removed faster than the first and third insulating layers because it is relatively thin.

The portions 180a, 180c of the third insulating layer formed above the elevated regions 100a and 100c are not completely removed during the etching.

By continuing the etching, the portions of the second insulating layer formed on the elevated regions continue to be removed, while exposed parts of first 140 and third 180 insulating layers are removed only slowly, if at all.

Referring to Fig. 2D, although the third insulating layer 180a, 180c formed above the elevated regions 100a, 100c is not completely removed, the second insulating layer 160 is removed from underneath.

Removal of the second insulating layer 160 causes lift-off of overlying portions 180a, 180c of the third insulating layer 180. Removal of third and first insulating layers is preferably reduced as much as possible. When the overlying portions 180a, 180c of the third insulating layer 180 are lifted off, the upper surface of the portion 180b of the third insulating layer lying within trench 120 is substantially coplanar with the upper surface of surrounding portions of the first insulating layer 140 overlying the elevated regions.

As shown in figure 2E, the substrate thereby acquires a planarised upper surface, largely corresponding to the original upper surface of the first insulating layer 140.

According to a variant of either the first or second embodiment of the present invention, the above-described first, second and third insulating layers may be formed by HDP CVD process or ECR CVD process, in which case, use of the argon sputtering process is unnecessary.

Upper edges of the pattern or the trench, that is, each interface between a recessed region and the adjacent elevated region, are preferentially etched during such CVD processes. A discontinuous second insulating layer comprising elevated and recessed portions of the second insulating layer, can be formed in this way. The resulting structure is similar to the structures shown in figures 1B, 2B.

The second insulating layer is preferably made of material having a relatively high etch selectivity to the materials of the first and third insulating layers. The second insulating layer may be composed of a material such as SiOF, PSG, BN or BPSG. The third insulating layer may be made of HDP CVD oxide or ECR CVD oxide.

Thus, the present invention provides a method for planarising a substrate with a planarised upper surface by etching, without the dishing phenomenon or contamination by slurry or particles.

Specific examples of etch conditions which may be used as the planarising etch in the method according to the invention, using the materials described above for the insulating layers, are as follows. The planarising etch must partially remove the third insulating layer from its upper surface and then remove the portion of second insulating layer overlying the elevated region, causing lift-off of corresponding portions of the third insulating layer.

An example of a suitable etch process is a wet etch using a solution of HF (hydrogen fluoride), in which case the relative etch rates of the first, second and third insulating layers are in the ratio 1:3:0.8, respectively.

Alternatively, a wet etch process using SC1 (ammonia NH₃ + hydrogen peroxide H₂O₂ + deionised water) as an etchant may be used, in which case the relative etch rates of the first, second and third insulating layers are in the ratio 1:7:12, respectively.

Although discussed with reference to semiconductor substrates, the invention is equally applicable to SOI (silicon on insulator) substrates, non-conductive substrates, or conductive substrates.

Although described with reference to certain structures commonly found in semiconductor devices, the invention may be applied to the planarisation of any combination of adjacent recessed and elevated regions. For example, each of several layers of metal interconnections in a semiconductor integrated circuit may be planarised according to the method of the present invention.

Although described with reference to certain particular materials, any suitable materials may be used for the first, second and third insulating layers, provided that the second insulating layer may be preferentially etched with respect to the first and third insulating layers.

Although discussed with reference to wet etching of third and second insulating layers, any suitable method may be used to selectively remove the second insulating layer, after partial removal of the third insulating layer. For example, a reactive ion etching (RIE) or other dry etching process may be used.

## Claims

1. A method for planarising a substrate, comprising the steps of:
a) preparing a substrate (10; 100) having an upper surface with uneven topography, including an elevated region (12; 100a) and an adjacent recessed region (17; 100b);
b) forming a first insulating layer (14; 140) on the elevated region and the recessed region;
c) forming a second insulating layer (16; 160) on the first insulating layer;
d) removing portions of the second insulating layer at an interface between the elevated region and the recessed region, to isolate a portion of the second insulating layer within the recessed region from a portion of second insulating layer overlying the elevated region;
e) forming a third insulating layer (18; 180) on the resultant surface;
f) partially removing the third insulating layer from its upper surface until a part of the portion of second insulating layer overlying the elevated region is exposed; and
g) removing the portion of second insulating layer overlying the elevated region, causing lift-off of corresponding portions (18a, 180a) of the third insulating layer.

2. A method according to claim 1 wherein the steps (f) and (g) are performed in a single etch step, selected such that the second insulating layer is etched at a faster rate than the third insulating layer or the first insulating layer.

3. A method according to claim 2 wherein the etch step is selected to completely remove the portion of second insulating layer overlying the elevated region before the portion of the second insulating layer within the recessed region is exposed.

4. A method according to any preceding claim wherein, during, or subsequent to, the step (d), an underlying portion of the first insulating layer is partially removed.

5. A method according to claim 4 wherein the step (d) and the step of partially removing an underlying portion of the first insulating layer are performed by a sputtering process using argon gas.

6. A method according to claim 1 wherein steps (c) and (d) are concurrently performed, the second insulating layer being deposited and at the same time etched, to etch the portions of the second insulating layer at the interface faster than other portions of the second insulating layer, and to expose underlying portions of the first insulating layer at the interface.

7. A method according to claim 6 wherein the second insulating layer is deposited and at the same time etched, in an HDP CVD process, or an ECR CVD process.

8. A method according to any preceding claim wherein the elevated region comprises a patterned layer (12) applied to the substrate, and the recessed region comprises the substrate, between elements of the patterned layer.

9. A method according to claim 8 wherein the patterned layer comprises an intermetal dielectric layer.

10. A method according to claim 8 wherein the patterned layer comprises a metal interconnect layer.

11. A method according to any preceding claim wherein the elevated region comprises the substrate (100a), and the recessed region comprises a trench (100b) within the substrate.

12. A method according to any preceding claim wherein the second layer is composed of one of the group consisting of SiOF, PSG, BN and BPSG.

13. A method according to any preceding claim wherein the third layer is composed of one of the group consisting of HDP CVD oxide and ECR CVD oxide.

14. A method according to claim 1 or claim 2 wherein step (f) and/or step (g) is/are performed by wet etching, using a solution of hydrogen fluoride HF.

15. A method according to claim 1 or claim 2 wherein step (f) and/or step (g) is/are performed by wet etching, using SC1 (NH₃ + H₂O₂ + water).

## Patentansprüche

1. Verfahren zur Planarisierung eines Substrats, das die folgenden Schritte umfasst:
(a) Erzeugen eines Substrats (10; 100) mit einer Oberseite mit unregelmäßiger Topographie, einschließlich einer erhabenen Region (12; 100a) und einer benachbarten eingetieften Region (17; 100b);
(b) Ausbilden einer ersten Isolierschicht (14; 140) auf der erhabenen Region und der eingetieften Region;
(c) Ausbilden einer zweiten Isolierschicht (16; 160) auf der ersten Isolierschicht;
(d) Entfernen von Abschnitten der zweiten Isolierschicht an einer Grenzfläche zwischen der erhabenen Region und der eingetieften Region, um einen Abschnitt der zweiten Isolierschicht innerhalb der eingetieften Region gegen einen Teil der zweiten Isolierschicht, die über der erhabenen Region liegt, zu isolieren;
(e) Ausbilden einer dritten Isolierschicht (18; 180) auf der resultierenden Oberfläche;
(f) teilweises Entfernen der dritten Isolierschicht von der Oberseite, bis ein Teil des Abschnitts der zweiten Isolierschicht, die über der erhabenen Region liegt, freigelegt ist; und
(g) Entfernen des Abschnitts der zweiten Isolierschicht, der über der erhabenen Region liegt, wodurch eine Abhebung entsprechender Abschnitte (18a, 180a) der dritten Isolierschicht bewirkt wird.

2. Verfahren nach Anspruch 1, wobei die Schritte (f) und (g) in einem einzigen Ätzschritt durchgeführt werden, der so ausgewählt wird, dass die zweite Isolierschicht mit einer höheren Rate geätzt wird als die dritte Isolierschicht oder die erste Isolierschicht.

3. Verfahren nach Anspruch 2, wobei der Ätzschritt so gewählt wird, dass der Abschnitt der zweiten Isolierschicht, der über der erhabenen Region liegt, vollständig entfernt wird, bevor der Abschnitt der zweiten Isolierschicht innerhalb der eingetieften Region freigelegt wird.

4. Verfahren nach einem der vorangehenden Ansprüche, wobei während dem oder im Anschluss an den Schritt (d) ein darunter liegender Abschnitt der ersten Isolierschicht teilweise entfernt wird.

5. Verfahren nach Anspruch 4, wobei der Schritt (d) und der Schritt, in dem ein darunter liegender Abschnitt der ersten Isolierschicht teilweise entfernt wird, durch ein Sputter-Verfahren unter Verwendung von Argongas durchgeführt werden.

6. Verfahren nach Anspruch 1, wobei die Schritte (c) und (d) gleichzeitig durchgeführt werden, wobei die zweite Isolierschicht abgeschieden und gleichzeitig geätzt wird, um die Abschnitte der zweiten Isolierschicht an der Grenzfläche schneller zu ätzen als andere Abschnitte der zweiten Isolierschicht, und um darunter liegende Abschnitte der ersten Isolierschicht an der Grenzfläche freizulegen.

7. Verfahren nach Anspruch 6, wobei die zweite Isolierschicht in einem HDP CVD-Verfahren oder einem ECR CVD-Verfahren abgeschieden und gleichzeitig geätzt wird.

8. Verfahren nach einem der vorangehenden Ansprüche, wobei die erhabene Region eine gemusterte Schicht (12) beinhaltet, die auf das Substrat aufgebracht ist, und die eingetiefte Region das Substrat zwischen Elementen der gemusterten Schicht beinhaltet.

9. Verfahren nach Anspruch 8, wobei die gemusterte Schicht eine dielektrische Zwischenmetallschicht einschließt.

10. Verfahren nach Anspruch 8, wobei die gemusterte Schicht eine Metallverbindungsschicht einschließt.

11. Verfahren nach einem der vorangehenden Ansprüche, wobei die erhabene Region das Substrat (100a) beinhaltet und die die eingetiefte Region einen Graben (100b) in dem Substrat beinhaltet.

12. Verfahren nach einem der vorangehenden Ansprüche, wobei die zweite Schicht aus einer Substanz aus der Gruppe zusammengesetzt ist, die aus SiOF, PSG, BN und BPSG besteht.

13. Verfahren nach einem der vorangehenden Ansprüche, wobei die dritte Schicht aus einer Substanz aus der Gruppe zusammengesetzt ist, die aus HDP CVD-Oxid und ECR CVD-Oxid besteht.

14. Verfahren nach einem der Ansprüche 1 oder 2, wobei der Schritt (f) und/oder der Schritt (g) durch Nassätzen unter Verwendung einer Lösung aus Fluorwasserstoff HF durchgeführt wird bzw. werden.

15. Verfahren nach einem der Ansprüche 1 oder 2, wobei der Schritt (f) und/oder der Schritt (g) durch Nassätzen unter Verwendung von SC1 (NH₃ + H₂O₂ + Wasser) durchgeführt wird bzw. werden.

## Revendications

1. Procédé pour planariser un substrat, comprenant les étapes qui consistent :
a) à préparer un substrat (10 ; 100) ayant une surface supérieure de topographie inégale, comprenant une région élevée (12 ; 100a) et une région adjacente en creux (17 ; 100b) ;
b) à former une première couche isolante (14 ; 140) sur la région élevée et la région en creux ;
c) à former une seconde couche isolante (16 ; 160) sur la première couche isolante ;
d) à enlever les parties de la seconde couche isolante à une interface entre la région élevée et la région en creux, afin d'isoler une partie de la seconde couche isolante dans la région en creux d'une partie de la seconde couche isolante s'étendant au-dessus de la région élevée ;
e) à former une troisième couche isolante (18 ; 180) sur la surface résultante ;
f) à enlever partiellement la troisième couche isolante de sa surface supérieure jusqu'à ce qu'une portion de la partie de la deuxième couche isolante s'étendant au-dessus de la région élevée soit mise à nu ; et
g) à enlever la partie de la deuxième couche isolante s'étendant au-dessus de la région élevée, provoquant un détourage de parties correspondantes (18a, 180a) de la troisième couche isolante.

2. Procédé selon la revendication 1, dans lequel les étapes (f) et (g) sont exécutées en une seule étape d'attaque, sélectionnée de manière que la deuxième couche isolante soit attaquée à une vitesse supérieure à celle de la troisième couche isolante ou de la première couche isolante.

3. Procédé selon la revendication 2, dans lequel l'étape d'attaque est sélectionnée de façon à enlever complètement la partie de la deuxième couche isolante s'étendant au-dessus de la région élevée avant que la partie de la deuxième couche isolante se trouvant dans la région en creux soit à nu.

4. Procédé selon l'une quelconque des revendications précédentes, dans lequel, pendant ou après l'étape (d), une partie sous-jacente de la première couche isolante est partiellement enlevée.

5. Procédé selon la revendication 4, dans lequel l'étape (d) et l'étape d'enlèvement partiel d'une partie sous-jacente de la première couche isolante sont exécutées par un processus de pulvérisation utilisant du gaz à base d'argon.

6. Procédé selon la revendication 1, dans lequel les étapes (c) et (d) sont exécutées simultanément, la deuxième couche isolante étant déposée et attaquée en même temps, pour attaquer les parties de la deuxième couche isolante situées à l'interface plus vite que d'autres parties de la deuxième couche isolante, et pour mettre à nu des parties sous-jacentes de la première couche isolante à l'interface.

7. Procédé selon la revendication 6, dans lequel la deuxième couche isolante est déposée et attaquée en même temps, dans un procédé de HDP CVD (dépôt chimique en phase vapeur activé au plasma à haute densité) ou un procédé ECR CVD (dépôt chimique en phase vapeur à résonance cyclotronique d'électrons).

8. Procédé selon l'une quelconque des revendications précédentes, dans lequel la région élevée comporte une couche (12) façonnée suivant un motif, appliquée sur le substrat, et la région en creux comprend le substrat, entre des éléments de la couche façonnée suivant un motif.

9. Procédé selon la revendication 8, dans lequel la couche façonnée suivant un motif comprend une couche diélectrique intermétallique.

10. Procédé selon la revendication 8, dans lequel la couche façonnée suivant un motif comprend une couche d'interconnexion métallique.

11. Procédé selon l'une quelconque des revendications précédentes, dans lequel la région élevée comprend le substrat (100a), et la région en creux comprend une tranche (100b) dans le substrat.

12. Procédé selon l'une quelconque des revendications précédentes, dans lequel la deuxième couche est composée d'une substance du groupe constitué du SiOF, du PSG, du BN et du BPSG.

13. Procédé selon l'une quelconque des revendications précédentes, dans lequel la troisième couche est composée d'une substance du groupe constitué d'un oxyde pour HDP CVD et d'un oxyde pour ECR CVD.

14. Procédé selon la revendication 1 ou la revendication 2, dans lequel l'étape (f) et/ou l'étape (g) est/sont effectuée(s) par attaque en milieu liquide, en utilisant une solution de chlorure d'hydrogène HF.

15. Procédé selon la revendication 1 ou la revendication 2, dans lequel l'étape (f) et/ou l'étape (g) est/sont effectuée(s) par une attaque liquide, en utilisant du SC1 (NH₃ + H₂O₂ + eau).
